# EUROPEAN PATENT SPECIFICATION

(11) **EP 2 211 217 B1**
(45) Date of publication and mention of the grant of the patent: **13.01.2016**
(21) Application number: 09000808.7
(22) Date of filing: 21.01.2009
(51) Int. Cl.: G02B 6/42, H05K 1/18

(54) **Printed circuit board fiberoptical transceiver in surface mount technology (SMT)**
Fiberoptischer Leiterplatten-Sender-Empfänger in Oberflächemontagetechnik
Émetteur-récepteur fibro-optique de carte de circuit imprimé dans une technologie de montage en surface

(43) Date of publication of application: 28.07.2010
(73) Proprietor: Harman Becker Automotive Systems GmbH, 76307 Karlsbad (DE)
(72) Inventor: Becht, Markus, 76359 Marxzell-Pfaffenrot (DE); Dittman, Markus, 76189 Karlsruhe (DE); Jurzitza, Dieter, 76131 Karlsruhe (DE); Mauderer, Hans, Peter, 76571 Gaggenau (DE)
(74) Representative: Grünecker Patent- und Rechtsanwälte PartG mbB

(56) References cited:
- EP-A2- 0 709 699
- EP-A2- 1 033 525
- WO-A-2006/066636
- WO-A1-2008/046188
- DE-A1- 10 225 543
- US-A- 5 903 440
- US-A1- 2005 035 443
- US-A1- 2005 276 547
- US-A1- 2006 257 081

## Description

### TECHNICAL FIELD OF THE INVENTION

The present invention relates generally to optical interconnection devices for optical communication systems and, more particularly, to optical interconnection devices for coupling an opto-electronic device to an optical fiber that is led in parallel to the circuit board onto which the opto-electronic device is arranged.

### BACKGROUND OF THE INVENTION

Telecommunication technology has been increasingly using optical fibers for signal transmission due to their many advantages over conventional electrical wires such as enhanced transfer rates of information over longer distances, cost effectiveness, and less power required to drive optical signals.

The extended use of optical fibers has in turn stimulated the development of optoelectronic components and optical fiber connectors specially adapted for handling the transmitted signals and for facilitating the optical interface with the wire harness.

For instance, the introduction of the MOST Technology (Media Oriented Systems Transport) into complex infotainment systems has led to the replacement of heavy copper wire harnesses by a optical fiber ring. This provides a high speed multimedia network for car applications as well as plug and play functionality with which new consumer electronic devices for digital entertainment and personal mobile devices can be safely and easily integrated in vehicles.

In the MOST ring, optical signals travel from one host device in the ring to the next via a polymer optical fiber (POF). At each host device, the incoming optical signals are received by an opto-electrical converter, also referred to as Fiber-Optic Receiver (FOR), and transformed into electrical signals to be processed. The processed electrical signals are then fed to an electro-optical converter, also referred to as Fiber-Optic Transmitter (FOX), which converts them into outgoing optical signals that are sent over the POF to the next device in the ring.

The optical interface or plug-in connection of the host devices to the external harness requires the use of suitable optical interface connectors that do not compromise the size constraints of the host device.

This is the case of devices having reduced dimensions such as handheld devices. Also, a large number of applications, such as computers, diagnostic devices and the like, frequently have two or more printed circuit boards stacked in a highly dense, parallel fashion in order to minimize their size.

Therefore, in order to satisfy the continuing need for electronic equipment of reduced size and/or densely packed circuit boards, there is a need for optical interfacing connectors of reduced dimensions that can be easily integrated in the host devices and provide a parallel optical interconnection to the external harness.

Pigtails are a commonly used optical connector that is also available in a 90° configuration for allowing an optical connection between the circuit board of the host device and an optical fiber cable led in parallel to the host circuit board. Generally, the pigtail already includes the Fiber-Optic Receiver and/or Fiber-Optic Transmitter housed inside a header. The electrical interface to the host circuit board is made via connecting pins protruding from a base of the header, which may also include other elements such as adapters and a sheet metal case for providing electromagnetic insulation from electromagnetic fields induced by neighboring circuits or from external fields. Ferrule holders at a lateral side of the header provide the connection to an optical fiber arriving at a right angle with respect to the header connecting pins, therefore, parallel to the host circuit board.

The plug-in connection to the external harness is provided by a connector. Depending on the type of pigtail, the header may be connected by a set of external optical fibers of a predetermined length to the connector, in this case the pigtail being referred to as "flexible pigtail", or the header may be integrated with the connector in a single unit, in this case the pigtail being designated as a "rigid pigtail", "micro-pigtail" or "Minipigtail".

However, pigtails have several limitations. Apart from the significant size of the header, pigtails are not suitable for automated mounting. Further, the header and/or the connector needs to be positioned in the host board before soldering, which implies that the optical devices in the header need to be resistant to the high temperatures used during the soldering process. Pigtail assemblies having pre-mounted pigtail fibers also require additional precaution measures to avoid exposing the optical fiber to soldering heat. Further, the through-hole interface of the header to the host board leads to a relatively high degree of parasitic inducting capacitances and resistance.

Similar problems are posed by the arrangement described in document US 2006257081 (A1), which describes a board assembly and an optical transceiver using same. The board assembly comprises a first rigid board and a second rigid board which are connected with each other by means of a flexible board. The flexible board is preformed before the attachment, so that the stress occurred at the flexible board can be relaxed.

Document US 2005035443 (A1) describes a device for connecting the terminal pins of a package for an optical transmitting and/or receiving device to a printed circuit board.

The device comprises a package with a base plate; at least two terminal pins, which respectively protrude perpendicularly from the base plate of the package, at least one of the terminal pins being a high-frequency terminal pin which transmits a high-frequency signal; a flexible conductor arrangement with a plurality of interconnects for providing an electrical connection between the terminal pins of the package and electrical contacts of a printed circuit board. The region of the conductor arrangement provides a connection to a high-frequency terminal pin which lies in a plane which is aligned substantially perpendicularly to the plane of the base plate.

Document WO 2006066636 (A1) describes an assembly comprising a ribbon cable containing a multi-core, flexible ribbon cable conductor, which is provided with electric or electronic components. The rear face of the conductor is connected to a dimensionally stable backing layer consisting of a non-woven material and for application purposes it is three-dimensionally pre-formed to adapt to the form of the installation site. The ribbon cable is supported by a separate supporting element, whose form is adapted to the ribbon cable and the installation site.

Document US 2005276547 (A1) describes an optical transceiver with a housing and coupled rigid and flex printed circuit boards. The housing includes a fiber optic connector adapted for coupling with an external optical fiber for transmitting and/or receiving an optical communications signal. The rigid printed circuit board is within the housing and includes an electrical connector for coupling with an external electrical cable or information system device, and for transmitting and/or receiving an information-containing electrical communications signal. A first interface connector is for receiving or transferring the electrical signal. A flexible printed circuit board is also within the housing and coupled to the rigid printed circuit board, including a second interface connector for mating with the first interface connector, and transmitting or receiving the electrical signal to or from the rigid printed circuit board. An electro-optical subassembly on the flex board is for converting between an electrical signal and a modulated optical signal. The flex board is adapted for coupling to the fiber optic connector.

Document DE 102 25 543 A1 describes a support (or carrier) for light elements of a motor vehicle lamp. The carrier has a plurality of lamp elements that are arranged in different swingable sections that can be swung with respect to a basic plane of the carrier. The swingable section is connected to a main section of the carrier via a swingable member defining the swing direction.

Document EP 1 033 525 A2 describes a flexible multiple LED module for luminaire housings of a motor vehicle. The flexible multiple LED module has a plurality of rigid printed circuit boards, which are each connected at one of their main surfaces to a flexible printed circuit board with a spacing between one another. A plurality of LEDs is mounted in the region of the rigid printed circuit boards and on the flexible printed circuit board.

Document WO 2008/046188 A1 describes a circuit board with regional flexibility and aims at providing a printed circuit board (PCB) adapted to reduce stress due to coupling of a structure to two different areas of the PCB. This involves mechanically isolating an area of the PCB intended for coupling with the structure by forming a stress-relief region around the area in order to create a localised movable area. By introducing such localised flexibility into the PCB in at least the area of one coupling, it is believed that any build-up of stress due to the coupling of the structure can be mitigated.

Document US 5 903 440 A describes a method of forming a circuit board with electronic assemblies lying in different planes, which includes providing a single circuit board with entire electronic assemblies pressed thereon. A channel is then formed in the circuit board of a predetermined depth to divide the circuit board into two separate, but integral portions. The circuit board is then bent at a point between the first and second portions of the circuit board such that the second portion of the circuit board can be bent between 0 and 180 degrees with respect to the first portion of the circuit board.

Document EP 0 709 699 A2 describes an optical module having a structure for defining a fixing position of a sleeve.

Other packaging arrangements providing a parallel optical interconnection between an optical fiber cable and the optoelectronic device have been proposed.

For instance, U.S. Patent No. 6,454,470 describes an optoelectronic interconnect module that includes an optical assembly of mirrors and lenses for deflecting the optical signal transmitted between an optical transmitting or receiving semiconductor die mounted on the module board and an optical fiber parallel to the board.

U.S. Patent No. 6,912,332 describes a parallel optical interconnection module that makes use of a reflection surface formed at the end of a parallel optical wave guide for changing the direction of the light transmitted between the optical wave guide and a light source/photo detector accommodated in a silicon optical bench and aligned under the wave guide. This technique uses a silicon optical bench for accommodating the light source/photo detector.

However, such prior art arrangements are based on using light bending means in optical association with the opto-electronic device for directing a part of the light emitted by the opto-electronic device or optical fiber onto the optical fiber or opto-electronic device, respectively.

Such arrangements not only require a considerable number of assembly parts but also alignment between the optical assemblies and the respective opto-electronic devices. This also implies a poor flexibility on the type of opto-electronic devices that can be used in association with these interconnection modules.

Opto-electronic devices and/or electro-optical devices having an optical cavity adapted to directly receive an optical fiber ferrule are currently available in through-hole and surface-mount packages that can be directly mounted on the circuit board of the host device.

However, the direction of the optical fiber connecting to such devices depends on the direction the operative optical axis of the optoelectronic device makes with the surface onto which the device is mounted.

Through-hole package devices having an operative optical axis that is perpendicular to the through-hole connecting pins, that is, to the direction of mounting are available and allowing a direct coupling to an optical fiber running parallel to the mounting board.

However, through-hole packages present many of the pigtails disadvantages. Through-hole devices have to be mounted before soldering and are not well adapted for automated mounting. Further, they require numerous soldered and/or wire-bonded connections with the host circuit board resulting in a relatively high degree of parasitic inducting capacitances and resistance.

Optoelectronic devices in surface-mount packages overcome many of the disadvantages of their through-hole mount counterparts. Their much smaller size allows achieving high circuit densities. Parasitic inducting capacitances are also reduced. Surface-mount technology (SMT) also allows a higher degree of automation, therefore, resulting in lower labor costs and better production and quality rates.

However, available surface-mount optoelectronic devices have an operative axis that is perpendicular to their mounting surface. Consequently, prior art configurations using surface-mount devices either have the optical fiber cable arriving at right angles to the circuit board or use light bending means in association with a parallel optical fiber cable. In both cases, a significant volume space is required for the optical interface.

Therefore, there is a need for solutions that allow to integrate surface-mount optoelectronic devices in the optical interface of optical communication systems and still meet the needs for densely packed parallel arrangements of circuit boards and/or reduced dimensions of the devices.

### SUMMARY OF THE INVENTION

The present invention has been made in view of the disadvantages and shortcomings of the prior art systems.

Accordingly, an object of the present invention is to provide an optical interconnection module and method of making thereof that allows to optically couple an optically active device mounted on a substrate board with an optical transmission line that is led in a preferred direction with respect to the substrate board and independently from the direction that the optical operative axis of the device might be, in a simple and cost-effective manner.

This object is solved by the subject matter of the independent claims. Advantageous and preferred embodiments of the present invention are the subject matter of the dependent claims.

The present invention is based on the idea of having a circuit board with multiple function circuit blocks and having a small section for arranging an optically active device (OAD) that can be brought in an upright position with respect to the main circuit board.

According to an example it is provided an optoelectronic interconnection module for use in optical communications that comprises a substrate having a main portion and a foldable portion formed on the substrate for arranging an optically active device therein. The foldable portion is adapted to be folded with respect to the main portion into a desired optical coupling orientation for which an optical operative axis of the optically active device arranged therein is substantially aligned with an optical transmission axis that is not perpendicular to the main portion.

By mounting the OAD device in a reserved section of the substrate that can be inclined or bowed with respect to the main portion, it is possible to align the optical operative axis of the OAD in any preferred direction. In this way, the present invention dispenses the use of cumbersome light bending means in association with the OAD for deviating the direction of transmission of optical signals. Furthermore, the location of the foldable portion is preferably chosen close to an edge of the circuit board in order to facilitate the optical interface with the external harness.

In a further development, the foldable portion has a substantially flat central surface for arranging the optically active device therein and an end part that is mechanically connected to the main portion by a bending edge. The bending edge is adapted to allow the substantially flat central surface to be bowed with respect to main portion by a desired bend angle.

When the optical operative axis of the optically active device is substantially perpendicular to its mounting surface, the desired optical coupling orientation corresponds to an orientation of the foldable portion for which said substantially flat surface becomes substantially perpendicular to the optical transmission axis. The direction of the optical transmission axis with respect to the main portion may be any.

In particular, when the preferred optical transmission axis is substantially parallel to the main portion, the desired optical coupling position corresponds to having the foldable portion inclined with respect to the main portion by an angle such that the optical operative axis of the optically active device becomes substantially parallel to the main portion.

In this way, it is possible to optically interface an optically active device with an optical fiber cable running in parallel with the main board, irrespective of the direction of its optical operative axis. In order to provide flexibility in the location of the optically active device in the substrate, the main portion may be provided with an opening and the foldable portion be mechanically connected over the opening by the bending edge. This opening is dimensioned such as to allow the foldable portion to be freely folded with respect to the opening.

In a further development, the foldable portion is shaped as a reed that is formed on the substrate by milling a milled slot along edges of the reed that are to be freed from the substrate. The bending edge is a bending slot formed at the end part of the foldable portion by partially milling the thickness of the substrate down to a desired bending thickness.

The desired bending thickness is chosen such as to increase the flexibility of the substrate in the bending region. Since the foldable portion and bending edge are formed from the same substrate board, the number of assembly parts of the optical interconnection module is then maintained to a minimum.

In order to provide electrical connections of the optically active device to external circuitry, the foldable portion may be adapted to electrically interface the optically active device arranged therein, and the substrate may comprise embedded conductive pathways adapted to electrically interface the foldable portion with the main portion. In this way, there is no need of performing electrical connections by wire-bonding between the main and the foldable portions.

According to an advantageous development, the substrate is a printed circuit board and comprises a plurality of contacts for electrically interfacing with a host circuit board of a host system. A portion of these contacts may be adapted to be electrically coupled to the optically active device. Therefore, the optoelectronic module can be used as an independent optical connector for interfacing a further circuit board.

In order to maintain the foldable portion in the desired optical coupling orientation with respect to the main portion, the optoelectronic interconnection module may be provided with a holding fixture adapted to attach to the foldable portion and to hold the foldable portion in the desired optical coupling orientation with respect to the main portion.

In particular, the holding fixture may comprise a first fixation element and a second fixation element, the first fixation element being adapted to snap to a first receiving element provided in the main portion, and the second fixation element being adapted to snap to a second receiving element provided in the foldable portion.

Alternatively or in addition, the holding fixture may comprise a first opening and a second opening that is connected to the first opening by an internal guiding path, the first and the second openings being disposed in the holding fixture so that when the holding fixture is attached to the foldable portion, the first opening is adapted to receive an end part of an optical transmission line, said end part being substantially aligned with the optical transmission axis, and the second opening is adapted to face the foldable portion and to enclose the optically active device arranged therein. The first opening may be provided as a ferrule receiving bore adapted to interconnect directly to the end part of the optical transmission line, said end part having a ferrule with an optical fiber held therein.

The holding fixture may further comprise an optical focusing device disposed between the first opening and the second opening for focusing an optical signal transmitted in the internal guiding path onto one of an optically active region of the optically active device and the end part of the optical transmission line.

In addition, the internal guiding path may comprise an optical guide adapted to transmit an optical signal between the optically active device and the end part of the optical transmission line.

According to a further development, the optically active device is an optical transceiver module comprising an electro-optical converter and an opto-electrical converter. By providing a complete and functional optical Transceiver-Module, with all necessary electronics, opto-electronics and shielding included, no additional circuitry related with the opto-electrical functions and/or respective wire bonding are needed.

In this case, in order to provide the optical coupling to the optical transceiver module, the holding fixture may be adapted to receive an optical transmission line comprising an incoming transmission line for transmitting an incoming optical signal to the opto-electrical converter component and an outgoing transmission line for transmitting an outgoing optical signal emitted by the electro-optical converter component.

In another advantageous developmen, the foldable portion and the optically active device are adapted to be electrically interfaced by surface mount technology.

According to a further advantageous development, the optical interconnection module comprises the optically active device arranged onto and electrically interfaced to the foldable portion. Therefore, the optical interconnection module of the present invention may be provided either in a pre-assembled state and without the optically active device so that the user may choose the optically active device to be mounted, or the optical interconnection module can be already provided as a complete optically interfacing module.

According to a further advantageous development, the main portion comprises a plurality of electronic circuits arranged therein. This implies that the present invention can be easily applied to main circuits boards of any device, such as a motherboard, and which require an optical interface.

In another development, the holding fixture is attachable to and removable from the foldable portion and the main portion. In this case, by providing an holding fixture that is rigidly attachable to but reversibly detachable from the substrate and the reed, the holding fixture can be easily removed from the assembled optical interconnection module and the foldable portion unfolded if necessary for maintenance or substitution of components arranged on the substrate.

According to an example it is provided a method of producing an optical interconnection module for use in optical communications, comprising the steps of: providing a substrate having a main portion and a foldable portion formed on the substrate, the foldable portion having a substantially flat central surface for arranging an optically active device therein and having an end part that is mechanically connected over the opening of the substrate by a bending edge; arranging the optically active device on the foldable portion; and folding the foldable portion to a desired optical coupling orientation for which an optical operative axis of the optically active device is substantially aligned with an optical transmission axis that is not perpendicular to the main portion.

In particular, the step of providing the substrate may comprise: forming said foldable portion with the shape of a reed by milling a milled slot across the thickness of the substrate and along edges of the reed that are to be freed from the substrate; and forming said bending edge by partially milling a bending slot with a specified depth across the thickness of the substrate and along the edge of the reed to be bended.

In a further development, the method may further comprise a step of providing a holding fixture for holding the foldable portion in the desired optical coupling orientation and shaped so as to mechanically couple with at least one of the freed edges of the foldable portion and to an attaching edge of the main portion that is oppositely disposed from the bending edge.

The present invention arrives at a solution that uses a concept similar to the concept of a "rigid pigtail" by using a transceiver module originally designed for "flexible pigtails". The solution provided by the present invention can be applied to all applications involving transmission of optical signals and optical interfacing with host devices such as in MOST systems with a maximum flexibility by using one type of transceiver that is suitable for all applications and a minimum of component parts.

Another advantage of the present invention lies in that the mounting of electronic components in the foldable and main portions, the bending process and the assembly with the holding fixture can be made as integral steps of a continuous manufacturing line.

### BRIEF DESCRIPTION OF THE FIGURES

Further features and advantages will become apparent from the following and more particular description of the invention as illustrated in the accompanying drawings, in which:
Fig. 1 is a top view showing a substrate of an optical interconnection module according to an embodiment of the present invention, the substrate having a mounting area for mounting an optically active device.
Fig. 2 is a cross-sectional view of the configuration illustrated in Fig. 1 along section x-x of Fig. 1.
Fig. 3 shows a cross-sectional view of a completely assembled optical interconnection module having a holding fixture according to an embodiment of the present invention.

### DETAILED DESCRIPTION OF THE INVENTION

Advantage embodiments of an optical interconnection module and a method for producing the same in accordance with the present invention will now be described in further detail with reference to the accompanying drawings.

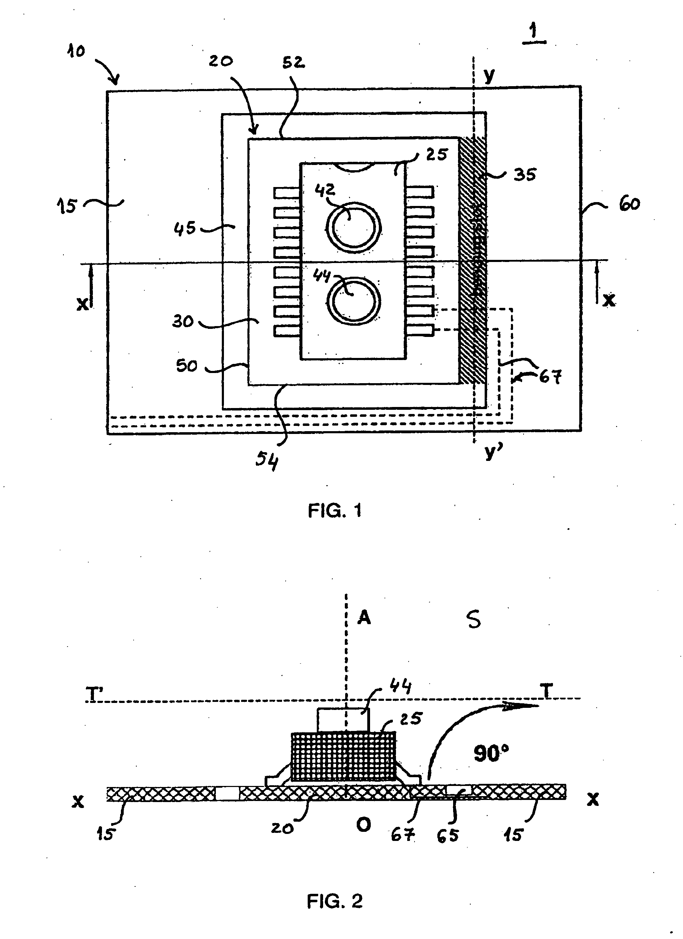

Fig. 1 is a top view showing a substrate of an optical interconnection module according to an embodiment of the present invention, the substrate having a mounting area for mounting an optically active device.

The substrate 10 has a main portion 15 and a foldable portion 20 that is formed on the substrate 10 for arranging therein an optically active device 25, that is to be optically coupled with an optical transmission line (not shown) having a predetermined, desired direction with respect to the main portion 15.

As used herein, the term "optical transmission line " refers to single or multiple-strand light guides. The light guide is preferably an optical fiber. The optical fiber may be a polymer optical fiber (POF) or may consist of glass or be coated with a material having an index of refraction lower than that of the fiber itself.

The term "optically active device" (OAD) as used herein refers to any opto-electronic transducer that is capable of converting electrical signals, voltage or current to electromagnetic radiation and/or converting electromagnetic radiation to electrical signals. Examples of such optically active devices include lasers, light emitting diodes (LED), photodiodes, optical transceivers, and other known semiconductor devices that are sensitive to light and light emitters. The term "optically active" does not imply that the device is currently in an active state of operation.

The substrate 10 is an electrical circuit component that provides mechanical support and an electrical interface to electronic circuit elements mounted thereto or forming part thereof. The substrate 10 may be designed for allowing electronic components to be mounted on one outer side or on opposite sides of the substrate 10.

Preferably, the substrate 10 is a printed circuit board (PCB), also commonly referred to as a printed wiring board or etched wiring board, having an electrically insulating layer and a layer of conductive pathways made of an electrically conducting material such as cooper or other materials suitable for transporting electric currents.

The conductive layer is preferably inside the substrate 10, embedded or sandwiched between two insulating layers (multi-layered PCB). Alternatively or in addition, the substrate 10 may comprise electrically conductive traces on one or both outer surfaces of the substrate board 10.

The insulating layer is preferably made of a flame retardant epoxy-glass fabric composite, such as the commonly used FR-4 material (Flame Retardant 4), which also provides a substantially rigid mounting board. However, any suitable material having sufficiently low impedance matching, crosstalk and skew such as ceramic, and/or similar materials well known in the art, may be used for the insulating layer.

The substrate 10 may further comprise contact regions (not shown) for electrically and mechanically connecting electronic components by through-hole technology and/or surface-mount technology, such as pin grid arrays, dual-in-line surface mount (SOIC) packages and ball grid arrays (BGA). The type and nature of circuit elements designed in through-hole or surface-mount technology as well as the techniques used for mounting and electrically connecting such elements to the substrate 10 are well known in the art, therefore, they will not be described in detail here.

Referring to Fig. 1, the main portion 15, also referred to in the following as a main board, has a substantially flat mounting surface with a large area suitable for arranging one or a plurality of electronic circuit elements and electronic devices, such as integrated chips (not shown). One or more of these electronic circuits may have functions that are completely independent from the function of the OAD 25 mounted on the foldable portion 20, therefore, not electrically interfaced to the foldable portion 20.

In particular, the substrate 10 according to the present invention may be used as a substrate 10 for a motherboard of a host device that requires an electro-optical interface and therefore including a plurality of circuit blocks.

The main portion 15 may also comprise electrical connecting pins, for instance, protruding from the rear side for interfacing with a further substrate or PCB (not shown).

The foldable portion 20 is a portion of the substrate 10 apart from the main portion 15 that is reserved for mounting the OAD 25. The foldable portion 20 has a substantially flat central surface 30 with a mounting area suitable for arranging the OAD 25 therein and provided with contact regions for electrically and mechanically connecting the OAD 25 (not shown).

The OAD 25 is preferably a complete and functional surface-mount optical transceiver module including the functions of a FOX and a FOT, all the electronic circuitry necessary for providing the electro-optical interface, such as a driver or pre-amplifier circuitry, as well as shielding. In this case there is no need of installing additional electronic circuits directly related with the functioning of the OAD module, such as a driver, in the main portion 15 and/or the foldable portion 20 as well as of electrically connecting such circuits by wire-bonding. Therefore, a high degree of automation can be achieved. However, the present invention may also be used for OADs having only the function of a FOX or a FOT.

The foldable portion 20 is provided with contact pads for connecting the surface-mount OAD 25 by surface-mount technology. However, the foldable portion 20 may be provided with other types of contact regions adapted to the type of OAD to be mounted, such as drilled vias or through-holes for mounting a through-hole OAD.

As illustrated in Fig. 1, the OAD 25 comprises two optically active areas, a receiving optically active area 42 that is sensitive to incoming optical signals and an emitting optically active area 44 that emits outgoing optical signals. The term "optically active area" refers to a region of the OAD that emits electromagnetic radiation or that is sensitive to incident electromagnetic radiation. An optical operative axis is generally defined as an axis that is perpendicular to and passing about the center of the optically active region. For instance, the optical operative axis of a LED corresponds to the average direction of the light emitted by the respective optically active region, which is substantially normal to this axis.

As illustrated in Fig. 1, the optically active areas 42, 44 are substantially parallel to the mounting surface of the OAD 25, therefore, the respective optical operative axis are substantially perpendicular to the surface onto which the OAD 25 is mounted (not shown).

An end part of the foldable portion 20 remains mechanically connected to the main board 15 by a bending region, which will be referred to as a bending edge 35, that allows the foldable portion 20 to be folded or bowed as a whole with respect to the main board 15 by a desired bend angle. The bend angle is defined as the angle made between the mounting surfaces of the foldable portion 20 and of the main portion 15, respectively.

The value of the desired bend angle depends on the direction of the optical operative axis OA with respect to the surface the OAD 25 is mounted onto and on the direction of the optical transmission axis to which the OAD will be optically coupled.

The foldable portion 20 and the bending edge 35 are preferably formed from the substrate 10 itself, so as to minimize the number of assembly parts of the optical interconnection module 1.

In the embodiment illustrated in Fig. 1, the foldable portion 20 is defined in an inner area of the substrate 10 that is intended for mounting the OAD 25, and is freed from contact with the substrate 10 except on the bending edge 35, so as to allow the orientation of the OAD 25 with respect to the mounting surface of the main board 15 to be freely changed.

The foldable portion 20 may be formed close to a border of the substrate 10 so as to minimize the length of optical fiber passing over the substrate 10. However, the location of the foldable portion 20 in the substrate 10 may be other, depending on other requirements such as circuit board design and the proximity of the OAD 25 to circuit blocks arranged in the main board 15 and with which the OAD 25 interacts. For example, the foldable portion 20 may be provided in an inner part of the main board 15 and/or be surrounded by electronic devices that populate the main board 15. Alternatively, the foldable portion 20 may be provided at a border of the substrate 10 such that one or more of its free edges coincide with the edges of the substrate 10.

The foldable portion 20 is defined on an initially flat substrate board 10 by milling a slot line 45 across the thickness of the substrate 10 and along the perimeter of the desired shape.

Machining is preferably performed before any electronic devices are assembled on the main portion 15 and/or on the foldable portion 20. Conventional machining tools such as carbide end-mill, fly cutter, or similar tool may be used. As will be readily recognized by those skilled in the art, the suitable machining technique is to be chosen based on the type of substrate 10 and parts to be cut.

In the illustrated embodiment, the foldable portion 20 is a reed with a rectangular-like flat surface formed from the substrate 10 by milling three straight slots that cross each other at substantially right angles.

Each milled slot 45 is cut across the full thickness of the substrate 10 so as to free the respective edge of the reed 20 from mechanical contact with the substrate 10, thereby defining free edges of the foldable portion 20. This defines an inner opening 18 in the main portion 15 with a shape that substantially matches the shape of the reed 20 and over which the reed 20 remains connected by the bending edge 35. The width of the milled slots 45 is such as to allow the reed 20 to be moved freely with respect to the substrate 10.

The size and shape of the foldable portion 20 may however vary based on design requirements for the specific circuit board, such as number and type of electronic components to be mounted therein, etc., and is not limited to the illustrated embodiment. For instance, it may be envisaged to design a foldable portion 20 having one or more free edges that coincide with an edge of the substrate 10 itself. In case all free edges of the foldable portion 20 coincide with the borders of the substrate 10, there is no need of the milled slots 45. Only the bending edge 35 needs to be defined.

The bending edge 35 defines a rotation axis yy' upon which the foldable portion 20 can be rotated as a whole by the desired bend angle so as to be brought into a desired optical coupling orientation with respect to the main board 15. Preferably, the bending edge 35 is a region of the substrate 10 whose flexibility is locally increased (or its rigidity reduced) for allowing bending by the desired bend angle without breaking the substrate 10 at the flexible joint provided by the bending edge 35.

In the embodiment illustrated in Fig. 1, the bending edge 35 is substantially parallel to an upper free edge 50 of the foldable portion 20 and transversally intersects two lateral free edges 52, 54 of the foldable portion 20. The bending edge 35 and the upper free edge 50 of the foldable portion 20 are substantially parallel to a nearest border 60 of the substrate 10.

The bending edge 35 is formed at the end part of the foldable portion 20 by machining a bending slot or score line in the substrate 10 along the intended axis yy'. The substrate thickness along the bending edge 35 is partially milled until reaching a predetermined bending thickness.

Referring to Fig. 2, which is a cross-sectional view of the configuration illustrated in Fig. 1 along section x-x of Fig. 1, and in a state prior to bending, the bending slot 35 is defined as a groove 65 having a rectangular cavity. The depth and width of the groove cavity 65 is determined based on the desired bend angle, recommendations and constraints given by the substrate suppliers and IPC standards, which depend on total thickness, bend radius, number of insulating and conductive layers for multi-layer circuit boards, the amount the substrate will bent, etc.

Typically recommended parameters for a FR-4 substrate are a remaining thickness of FR-4 in the bend region between 0.20 and 0.25 mm, independently from the total thickness of the substrate. For total thicknesses typically used in substrates and a bend angle of 90°, it is recommended a 6.5 mm width groove.

The parameters of the bend region also depend on whether the optical connection module 1 is intended for static applications, in which the substrate board 10 is installed folded on a device and it will not be unfolded again during the lifetime of the circuit board, or for dynamic applications and/or semi-dynamic applications, in which the substrate board 10 is folded/unfolded regularly or occasionally, respectively, for maintenance or repair of components.

The cavity of the groove 65 is not limited to a rectangular shape as shown in Fig. 2, but may be provided with other features that offer the advantage of increased torsional stiffness as well as the possibility of adhesive bonding of the final bent configuration. For instance, the bottom of the groove cavity 65 may be structured with a saw tooth surface.

The bending can be performed through a suitable bending apparatus in the assembly chain of the optical interconnection module 1 and after the respective electronic devices have been populated in the main portion 15 and in the foldable portion 20. Alternatively, the substrate 10 assembled with the electronic devices can be delivered in an unfolded state to be folded at a later stage.

The connection of the OAD 25 to external circuitry is realized via conductive pathways provided on the substrate 10 that interconnect electrically the foldable portion 20 with the main portion 15. These conductive pathways may be signal lines 67 located inside the substrate board 10 in a manner so that they are undisturbed during the machining process. Preferably, the signal lines 67 are formed on a conductive layer located inside the substrate at a depth greater than the depth of groove cavity 65 so that they are not removed during the milling of the bending edge 35. Preferably, the signal lines 67 are designed so as to cross the bending region in a direction perpendicular to the bending edge 35 for reducing the effect of twisting forces on the signal lines 67 during bending.

However, in specific cases, the electrical connection may be made by conductive pathways located at one of the outer surfaces of the substrate 10 or by other techniques such as wire bonding.

Generally, in order to optically couple the OAD 25 with an optical transmission axis TT' having a preferred direction and without the use of light bending means, the mounting plane of the foldable portion 20 needs to be bowed or folded up as a whole with respect to the plane of the main board 15 by a given bend angle such as to bring the optical operative axis OA of the OAD 25 into a direction that is substantially parallel to the desired optical transmission axis TT'.

The desired optical transmission axis TT' defines a preferred direction along which the optical signals arrive at or leave the OAD 25.

The desired optical coupling orientation corresponds to the relative orientation of the foldable portion 20 with respect to the main board 15 for which the optical operative axis OA of the OAD 25 mounted in the foldable portion becomes parallel to the desired optical transmission axis TT'. The desired optical coupling orientation depends therefore on the direction of the optical operative axis OA relative to the surface the OAD 25 is mounted onto and on the orientation of the preferred optical transmission axis TT' with respect to the main board 15.

In the embodiment illustrated in Fig. 2, the desired optical transmission axis TT' is substantially parallel to the main board 15. Prior to folding, the foldable portion 20 is substantially in the same plane of the main board 15 and the optical operative axis OA of the OAD 25 makes an angle of substantially 90° with the mounting planes of the foldable portion and main board 15.

When the foldable portion 20 is folded up from an initial in-plane orientation, in which the mounting plane of the foldable portion 20 substantially coincides with the mounting plane of the main board 15, to an out-of-plane orientation by a certain bend angle, the direction of the optical operative axis OA rotates on a plane transverse to the mounting plane of the main portion 15 by the same angle amount.

In the present embodiment, the plane of the foldable portion 20 is folded up or bowed in a clockwise direction by a bend angle of 90° about the axis yy' defined by the bending edge 35 for bringing the optical operative axis OA in alignment with the desired optical transmission axis TT'. This means that the optical operative axis OA rotates in a clockwise direction by 90° to acquire a direction that is substantially parallel to the mounting plane of the main portion 15.

However, the present invention can be advantageously used for optically coupling the OAD 25 with an optical transmission axis TT' having any other preferred direction with respect to the main board 15 by simply adjusting the desired optical coupling orientation, that is the desired bend angle, to the particular situation and using the same substrate board 10.

In particular, in case the optical operative axis OA is substantially perpendicular to the mounting surface of the OAD 25 and the desired optical transmission axis TT' is not perpendicular to the main board 15, the desired optical coupling orientation corresponds to an out-of-plane orientation for which the mounting surface 30 of the foldable portion 20 becomes substantially perpendicular to the desired optical transmission axis TT'.

On the other hand, in case the optical operative axis of the OAD 25 is not perpendicular to its mounting surface, the angle amount by which the foldable portion 20 is inclined is similarly adapted so as to bring the optical operative axis in alignment with the desired optical transmission axis TT'.

The folding of the foldable portion 20 may be performed as an integral step of a continuous assembly process and is preferably performed after mounting and electrically interfacing the OAD 25 in the foldable portion 20 and/or the other eventual electronic devices in the main board 15 (not shown).

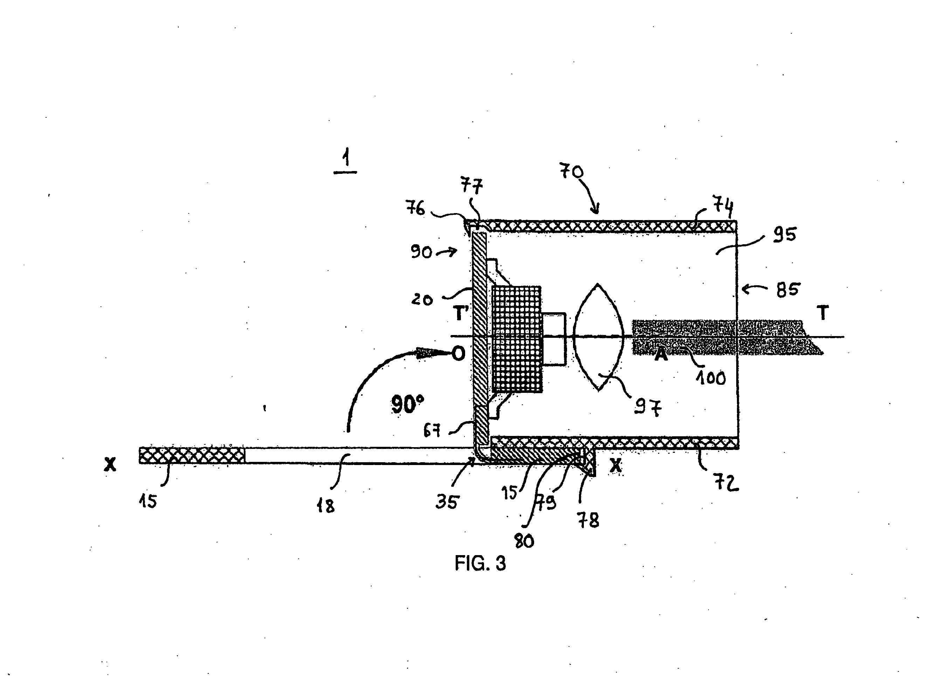

Fig. 3 shows a cross-sectional view of a completely assembled optical interconnection module having a holding fixture according to an embodiment of the present invention.

As illustrated in Fig. 3, the optical interconnection module 1 may comprise a holding fixture 70 that is attached to the foldable portion 20 and the main portion 15 after the OAD has been mounted for holding the foldable portion 20 after bending in the desired optical coupling orientation with respect to the main portion 15, thereby maintaining rigidly the entire folded structure in the desired coupling configuration.

Preferably, the holding fixture 70 is a cuboidal, hollowed connector having a longitudinal axis that is substantially parallel to the optical transmission axis TT' and transverse to the bending edge 35 and the foldable portion 20 when assembled to the optical interconnection module 1.

The external dimensions of the holding fixture 70 depend on the dimensions of the foldable portion 20, the location of the foldable portion 20 with respect to an attaching border 80 of the main portion 15 to which the holding fixture 70 will be attached to and on the desired bend angle. Preferably, the holding fixture 70 has a cross-section that substantially matches the mounting surface of the foldable portion 20.

A lower base 72 of the holding fixture 70 that faces the main portion 15 has a longitudinal length that is at least equal to distance between the bending edge 35 and the attaching border 80 of the main portion 15. The transversal length is substantially equal to the length of the bending edge 35. The dimensions of an upper part 74 of the holding fixture 70 are substantially the same as of the lower base 72. However, the holding fixture 70 may be provided with different transverse and longitudinal lengths of the upper part 74 and the lower base 72, depending on the specific situation.

The holding fixture 70 has at least two fixation elements that are preferably adapted to snap into corresponding receiving elements provided in the foldable and main portions 15, 20, for rigidly fixing the holding fixture 70 to the substrate 10. The fixation elements and the corresponding receiving elements may be designed so that the holding fixture 70 can be easily attached to and/or removed from the foldable portion 20 and the main portion 15, respectively.

Referring to Fig. 3, a first fixation element 76 is provided on the upper part 74 of the holding fixture 70 as a fixation groove 77 that is formed on the inner side of the upper part 74 on the side facing the foldable portion 20.

The fixation groove 77 runs parallel to the border of the upper part 74 of the holding fixture 70 such that when snapped to the foldable portion 20, it is substantially parallel to and approximately located above the bending edge 35 so as to hold the foldable portion 20 with the desired bend angle, in the illustrated embodiment 90°. However, the fixation groove 77 may be located at the left or right side above the bending edge 35 if the desired inclination for the foldable portion 20 should be less or greater than 90°.

As illustrated in Fig. 3, a second fixation element 78 is located on the outer side of the lower base 72 of the holding fixture 70 and is provided as a protruding part having an arrow-shaped extremity with an indentation 79 or lateral groove on the side facing the main portion 15 for snapping to an attaching edge 80 of the main portion 15. The attaching edge 80 is the border of the main portion 15 that is closer to the bending edge 35. The second fixation element 78 may extend along the whole or only a part of the transversal length of the holding fixture 70 and is located approximately at a distance from the end of the lower base 72 that is substantially equal to the distance between the bending edge 35 and the attaching border 80 of the main portion 15.

The fixation groove 77 and the indentation 79 have rectangular shaped cavities of a width that substantially matches the total thickness of the substrate 10 so that they can be snapped to the edges of the reed 20 and of the main board 15 by applying a small pressure to the fixation elements 76, 78 and remain fastened once this pressure is removed. The holding fixture 70 may be later detached from the substrate if necessary by applying a counter force to the fixation elements 76, 78.

In order to assemble the holding fixture 70 to the optical interconnection module 1, the foldable portion 20 is first bowed up by a certain bend angle sufficient for snapping the first fixation element 76 to the upper free edge 50 of the foldable portion 20. In this case, the upper free edge 50 itself serves the purpose of a first receiving element that is provided in the foldable portion 20 for receiving and attaching the first fixation element 76. The foldable portion 20 is then brought to the desired optical coupling orientation and the second fixation element 78 is snapped into the attaching border 80 of the main portion 15. In this case, the attaching border 80 serves the purpose of a second receiving element that is provided in the foldable portion 20 for receiving and attaching the second fixation element 78.

In order to increase the mechanical stability of the optical interconnection module 1 in the folded configuration, additional fixation elements similar to the first fixation element 76 may be provided in the lateral sides of the holding fixture 70 (not shown) for snapping to the lateral free edges 52, 54 of the reed.

As readily understood by a person skilled in the art, the number and configuration of the fixation elements provided in the holding fixture 70 and/or of the receiving elements provided in the foldable portion 20 and main portion 15 are not limited to the illustrated embodiment but other holding arrangements and/or snapping mechanisms suitable to keep the folded structure in the desired configuration may be adopted.

For instance, in order to compensate for pull- and shear forces exerted on the optical connector, the second fixation element 78 may be provided as two or more parallel protruding parts separated by a given distance and which can be brought close to each other by a slight compression so as to snap into receiving elements provided in the main portion 15, such as receiving holes. The extremity of each protruding part may be provided with an arrow-shape end and a lateral indentation disposed so as to fit to the opposing edge of the receiving hole, thereby rigidly attaching the holding fixture 70 to the main portion 15 once the slight compression is released.

The fixation elements may also be provided as small hooks distributed at certain points on the holding fixture 70. Alternatively, the fixation elements may be provided as pins that protrude longitudinally and transversally from the holding fixture 70 for snapping into matching holes that are drilled in the foldable and main portions for this purpose.

The above-described fixation elements provide a reversible fixation means that can be attached to and removable from the foldable portion 20 and the main board 15 if necessary, thereby allowing to unfold the foldable portion 20 from the desired optical coupling position for maintenance or substitution of electronic components.

However, a holding fixture 70 without detachable fixation elements such as described above may be provided. For static applications in which the unfolding of the foldable portion 20 is not required, the holding fixture 70 may be permanently fixed to the foldable portion 20 and/or to the main board 15. For instance, the holding fixture 70 may be provided as a molded plastic, hollow block whose sides facing the foldable portion 20 and the main portion 15 are permanently bonded to these portions.

In order to allow the optical coupling of the OAD 25 with an optical transmission line, the holding fixture 70 is provided with two openings, a first opening 85 and a second opening 90, connected to each other by an internal guiding path 95.

The first opening 85 and the second opening 90 are disposed in the holding fixture 70 so that when the holding fixture 70 is attached to the foldable portion 20, the first opening 85 is adapted to receive an end part 100 of an optical transmission line, the end part 100 being substantially aligned with the desired optical transmission axis TT', and the second opening 90 is adapted to face the foldable portion 20 and to enclose the optically active device 25 arranged therein. The internal guiding path 95 provides a path for the transmission of optical signals between the end part 100 of the optical transmission line and an optically active surface of the OAD 25.

In the embodiment illustrated in Fig. 3, the two openings are diametrically opposed to each other and the internal guiding path 95 extends along the longitudinal axis of the holding fixture 70 in a direction substantially perpendicular to the mounting surface of the reed 20.

The first opening 85 is adapted to receive an external connector or plug (not shown) containing an optical fiber ferrule, thereby providing the interface to the external harness.

The second opening 90 faces toward the reed 20 and has internal dimensions suitable for enclosing the OAD 25 when the holding fixture 70 is snapped to the reed 20. Once snapped, the second opening 90 contacts uniformly the mounting surface 30 of the reed 20, thereby preventing external light coming from the lateral side from interfering with the optical signals transmitted in the internal guiding path 95. In case the OAD 25 is already shielded against electromagnetic radiation, the holding fixture 70 does not need to include a metallization layer for providing effective electromagnetic shielding to the OAD 25.

The holding fixture 70 may accommodate an optical focusing device 97 such as a lens, in the internal guiding path 95 and disposed between the first opening 85 and the second opening 90 for focusing the transmitted optical signal onto the optically active region of the optically active device 25 and/or on the end part 100 of the optical transmission line. The focusing of the optical signals transmitted through the internal guiding path 95 may be necessary when the distance between the optically active region of the OAD 25 and the end of the optical fiber ferrule is comparatively large on account of the length of the holding fixture 70. The longitudinal length of the holding fixture 70 depends among other factors on the distance between the bending edge 35 and the attaching border 80 of the substrate 10, that is, on the location of the OAD 25 on the substrate 10.

In the illustrated embodiment, the focusing element 97 is a convex lens, which is arranged at a central part of the internal guiding path 95 and transverse to the direction of optical transmission TT'. However, the holding fixture 70 may be provided without the optical focusing device 97 in case the optical transmission line is an optical fiber ferrule already including a lens at its coupling end.

In addition, or alternatively, the holding fixture 70 may comprise a light waveguide for bridging a part or the totality of the gap between the optically active surface of the OAD 25 and the end part 100 of the optical transmission line (not shown).

As will be readily understood by those skilled in the art, the holding fixture 70 can be easily modified to integrate one or a plurality of light paths for allowing the reception of one or a plurality of optical transmission lines so as to allow the optical coupling between one or a plurality of optically active regions of the OAD 25 and an external optical fiber cable, comprising one or a plurality of optical transmission lines.

In the present embodiment, the OAD 25 is a transceiver module integrating the functions of a FOX and FOT, therefore, having two optically active regions 42, 44, respectively. In this case, the holding fixture 70 is adapted to receive two optical transmission lines. An incoming optical transmission line for transmitting an incoming optical signal to the receiving optically active surface 42 of the FOX and an outgoing optical transmission line for transmitting an outgoing optical signal emitted by the emitting active region 44 of the FOT.

In addition, the holding fixture 70 may comprise two integrated light paths with included light guides (lens, optical fiber, etc.). Both paths are in a fixed location and provide a contact element to the external harness. The oppositional contact elements are available on the transceiver module and in optical alignment with the integrated light paths.

In case the OAD 25 is a FOX or a FOT, therefore, having a single optically active surface, the holding fixture 70 comprises a single light path and the optical elements required for coupling the OAD 25 with a single optical transmission line.

As will be readily understood by those skilled in the art, the holding fixture 70 can be easily modified to integrate one or a plurality of light paths for allowing the reception of one or a plurality of optical transmission lines so as to perform the optical coupling with one or a plurality of optically active regions of the OAD 25.

The second opening 90 may be specially designed to receive ferrules from a preferred manufacturer and/or of a preferred type, such as ferrules produced by laser welding, gluing and crimping.

In case the OAD 25 is adapted for being directly interfaced to an optical fiber ferrule without the need of any additional coupling parts, the holding fixture 70 is provided without any optical focusing devices or light guides. In this case, the second opening 90 and the internal guiding path 95 define an internal hollow that serves the only purpose of guiding the optical fiber ferrule to the receiving cavity of the OAD and of eventually maintaining the direction of the optical fiber with respect to the main board 15.

As will be readily understood by those skilled in the art, many modifications and/or combinations of the embodiments described above may be carried out within the scope of the invention.

As illustrated in Fig. 3, the bending slot 35 is preferably milled on the same side S of the foldable portion 20 that approaches the main portion 15 upon folding. This allows to reduce the effect of compression that is increased in the substrate layers that are closer to the inner side of the bending edge 35 when the substrate board 10 undergoes bending and to prevent the bending region from breaking during or after the bending procedure. However, it may be envisaged to define the bending slot 35 on the outer side of the foldable portion 20, for instance, when conductive traces running through the bend region need to be placed in a layer close to the inside of the bending slot 35 for reducing tension effects on the conductive traces.

The above description was done with respect to a substrate 10 that is substantially rigid and from which a selected portion is made foldable with respect to the main portion by forming a region of increased flexibility in the substrate, thereby arriving at a pseudo-flex substrate having flexible parts. This pseudo-flex technique allows to reduce the number of assembly parts and to simplify the assembly of the optical interconnection module 1.

However, alternative configurations may also be realized using a rigid-flexible circuit board, and in which the main board 15 and the foldable board are provided as two separate rigid boards that are mechanically bond together by one or more flexible insulating layers that allow the plane of the foldable board to be inclined with respect to the main board by any angle. For instance, the foldable portion 20 could be realized by attaching a separate rigid board of an area suitable for arranging the OAD 25 to an edge of the main board 15 or to an opening of the main board 15 of a matching size by a stripe of flexible insulating material.

Conventional flexible materials used in flexible circuit boards include the flexible plastic films KAPTON, NOMEX, and TEFLON. These materials are employed for providing flexible regions of printed circuit boards, joining rigid regions of the circuit together and/or providing flexible connections to external assemblies.

Both rigid and flexible substrates can be provided on one or both sides with a copper laminate circuit. Electrical connection between the separate rigid boards can be provided by conductive traces in the connecting flexible regions or by wire bonding.

Further, the optical interconnection module 1 according to the present invention may be provided with a substrate having a plurality of foldable portions, each foldable portion arranging one or more OADs and being located at distinct parts of the substrate so as to provide a plurality of optical interconnections with a plurality of optical fiber cables. Further, each foldable portion may be designed differently depending on the OAD arranged therein and be folded by different bending angles depending on the desired optical coupling orientation.

Further, the side of the substrate towards which the foldable portion is bowed is not limited to the above described embodiments. For instance, the foldable portion may be folded towards the side of the main portion that is not populated with electronic devices so as to provide an optical coupling to an optical transmission axis TT' located on the side opposed to the mounting surface of the substrate board. In addition, the foldable portion 20 may have the OAD 25 mounted on a side that is opposite to the side that approaches the main portion 15 upon bending. For instance, the foldable portion 20 may be folded down or bowed in a counterclockwise direction with respect to the main board 15.

The position of the bending edge 35 is also not limited to the illustrated embodiments. For instance, the bending edge 35 may be provided either at the left or at the right of the opening over which the foldable portion 20 is attached to. Instead of being parallel to one of the main portion 15 borders, the bending 35 may be define with other orientation, for instance, it may be aligned along a diagonal and intersecting two borders of the main portion.

Furthermore, the parameters for the bending edge 35 mentioned above relate to typical parameters for a non-heated bending process. In case the bending process is assisted by a heating treatment in the bending region so as to increase the flexibility of the insulating material, the parameters of the bending edge 35 may be considerably different for the same bend angle. In particular, the desired thickness of the bending edge 35 can be substantially larger than for a non-heated bending process and thick enough so as to remain rigid at ambient temperatures. In this last case, once folded up, the optical interconnection module 1 may even dispense the use of additional holding means for holding the foldable portion in the desired optical coupling orientation. This is particularly useful in the case that it is desired to couple the OAD to an optical transmission axis that is not parallel to the main board.

As it will be also realized by those skilled in the art, although the above-described embodiments refer preferentially to the substrate being a printed circuit board, the present invention may be used to provide an optical interconnection module having a substrate that is an independent platform of a small area that provides only the mechanical support and electrical interface to the OAD 25. In this case, the main portion 15 is not populated with other electronic devices, and may only include connecting pins for electrically interfacing the OAD mounted on the foldable portion with another circuit board.

### REFERENCE SIGNS

- optical interconnection module: 1
- substrate: 10
- main portion: 15
- inner opening in the main portion: 18
- foldable portion: 20
- optically active device: 25
- flat central surface of foldable portion: 30
- bending edge, bending slot: 35
- receiving optically active area: 42
- emitting optically active area: 44
- milled slot: 45
- upper free edge of foldable portion: 50
- lateral free edges of foldable portion: 52, 54
- nearest border of substrate: 60
- groove cavity of bending edge: 65
- side of the bending slot: S
- signal lines: 67
- optical operative axis: OA
- optical transmission axis: TT'
- holding fixture: 70
- lower base of the holding fixture: 72
- upper part of the holding fixture: 74
- first fixation element: 76
- fixation groove of first fixation element: 77
- second fixation element: 78
- indentation of second fixation element: 79
- attaching border of main portion: 80
- first opening of holding fixture: 85
- second opening of holding fixture: 90
- internal guiding path: 95
- optical lens: 97
- end part of optical transmission line: 100

## Claims

1. An optoelectronic interconnection module for use in optical communications, comprising:
an optically active device (25) adapted to receive and/or transmit optical signals; and
a substrate (10) having a main portion (15) and a foldable portion (20) adapted to mount the optically active device (25) therein;
wherein the foldable portion (20) has a substantially flat, central surface (30) for arranging the optically active device (25) and an end part that is mechanically connected to the main portion (15) by a bending edge (35), the foldable portion (20) being adapted to be folded at the bending edge (35) with respect to the main portion (15) into a desired optical coupling orientation for which an optical operative axis (OA) of the optically active device (25) is substantially aligned with an optical transmission axis (TT') that is not perpendicular to the main portion (15);
**characterized in that**
the substrate (10) is made from a single, rigid circuit board, from which the main portion (15), the foldable portion (20) and the bending edge (35) are formed; wherein
the foldable portion (20) is formed from an inner area of the substrate (10) by forming a slot along edges (50, 52, 54) of the foldable portion (20) that are to be freed from the main portion (15); and
the bending edge (35) is a bending slot formed at the end part of the foldable portion (20) by partially reducing the substrate thickness down to a desired bending thickness for which the flexibility of the substrate (10) is increased, the bending slot (35) being adapted to allow the substantially flat, central surface (30) of the foldable portion (20) to be bowed with respect to the main portion (15) by a desired bend angle.

2. The optoelectronic interconnection module according to claim 1, wherein
said optical transmission axis (TT') is substantially parallel to the main portion (15), and
when the optical operative axis (OA) of the optically active device (25) is substantially perpendicular to its mounting surface, said desired optical coupling orientation corresponds to an orientation of the foldable portion (20) for which said substantially flat central surface (30) becomes substantially perpendicular to the optical transmission axis (TT').

3. The optoelectronic interconnection module according to any one of claims 1 to 2, wherein:
the main portion (15) has an opening;
the foldable portion (20) is mechanically connected over the opening by the bending edge (35); and
the opening is dimensioned such as to allow the foldable portion (20) to be freely folded with respect to the opening.

4. The optoelectronic interconnection module according to any one of claims 1 to 3, wherein:
said foldable portion (20) is shaped as a reed that is formed on the substrate (10) by milling a milled slot (45) along the edges (50, 52, 54) of the reed that are to be freed from the main portion (15); and
said bending slot (65) is formed at the end part of the foldable portion (20) by partially milling the thickness of the substrate (10) down to the desired bending thickness.

5. The optoelectronic interconnection module according to any one of claims 1 to 4,
wherein
the foldable portion (20) is adapted to electrically interface the optically active device (25) arranged therein, and
the substrate (10) comprises embedded conductive pathways (67) adapted to electrically interface the foldable portion (20) with the main portion (15).

6. The optoelectronic interconnection module according to any one of claims 1 to 5, wherein:
the substrate (10) is a printed circuit board, and
the printed circuit board comprises a plurality of contacts for electrically interfacing with a host circuit board of a host system, a portion of said contacts being adapted to be electrically coupled to the optically active device (25).

7. The optoelectronic interconnection module according to any one of claims 1 to 6, comprising:
an holding fixture (70) adapted to attach to the foldable portion (20) and to hold the foldable portion (20) in the desired optical coupling orientation with respect to the main portion (15).

8. The optoelectronic interconnection module according to claim 7, wherein
the holding fixture (70) comprises a first fixation element (76) and a second fixation element (78),
the first fixation element (76) is adapted to snap to a first receiving element provided in the main portion (15), and
the second fixation element (78) is adapted to snap to a second receiving element provided in the foldable portion (20).

9. The optoelectronic interconnection module according to claim 7 or claim 8, wherein
the holding fixture (70) comprises a first opening (85) and a second opening (90) that is connected to the first opening (85) by an internal guiding path (95), and
the first (85) and the second openings (90) are disposed in the holding fixture (70) so that when the holding fixture (70) is attached to the foldable portion (20):
the first opening (85) is adapted to receive an end part (100) of an optical transmission line, said end part (100) being substantially aligned with the optical transmission axis (TT'), and
the second opening (90) is adapted to face the foldable portion (20) and to enclose the optically active device (25) arranged therein.

10. The optoelectronic interconnection module according to claim 9, wherein
the first opening (85) is a ferrule receiving bore adapted to interconnect directly to the end part (100) of the optical transmission line (100), said end part (100) having a ferrule with an optical fiber held therein.

11. The optoelectronic interconnection module according to claim 9 or claim 10, wherein
the holding fixture (70) further comprises an optical focusing device (97) disposed between the first opening (85) and the second opening (90) for focusing an optical signal that is transmitted in the internal guiding path (95) onto one of an optically active region (42, 44) of the optically active device (25) and the end part (100) of the optical transmission line.

12. The optoelectronic interconnection module according to any one of claims 9 to 11,
wherein
the internal guiding path (95) comprises an optical guide adapted to transmit an optical signal between the optically active device (25) and the end part of the optical transmission line (100).

13. The optoelectronic interconnection module according to any one of claims 1 to 12,
wherein
said optically active device (25) is an optical transceiver module comprising an electro-optical converter component and an opto-electrical converter component, and
said holding fixture (70) is adapted to receive an optical transmission line comprising an incoming transmission line for transmitting an incoming optical signal to the opto-electrical converter component and an outgoing transmission line for transmitting an outgoing optical signal emitted by the electro-optical converter component.

14. The optoelectronic interconnection module according to any one of claims 1 to 13,
wherein
said optically active device (25) is arranged onto and electrically interfaced to the foldable portion (20), and
wherein the foldable portion (20) and the optically active device (25) are adapted to be electrically interfaced by surface mount technology.

15. The optoelectronic interconnection module according to any one of claims 1 to 14,
wherein
the main portion (15) comprises a plurality of electronic circuits arranged therein, and
the holding fixture (70) is attachable to and removable from the foldable portion (20) and the main portion (15).

16. A method of producing an optoelectronic interconnection module for use in optical communications, comprising the steps of:
providing a substrate (10) having a main portion (15) and a foldable portion (20) adapted to mount an optically active device (25) therein, the foldable portion (20) having a substantially flat, central surface (30) for arranging the optically active device (25) and an end part that is mechanically connected to the main portion (15) by a bending edge (35);
mounting the optically active device (25) on the foldable portion (20); and
folding the foldable portion (20) at the bending edge (35) with respect to the main portion (15) into a desired optical coupling orientation for which an optical operative axis (OA) of the optically active device (25) is substantially aligned with an optical transmission axis (TT') that is not perpendicular to the main portion (15);
**characterized in that**
the substrate (10) is made from a single, rigid circuit board,
the step of providing the substrate (10) including forming the main portion (15), the foldable portion (20) and the bending edge (35) from the substrate (10) itself; wherein
the foldable portion (20) is formed from an inner area of the substrate (10) by forming a slot along edges (50, 52, 54) of the foldable portion (20) that are to be freed from the main portion (15), and
the bending edge (35) is a bending slot formed at the end part of the foldable portion (20) by partially reducing the substrate thickness down to a desired bending thickness for which the flexibility of the substrate (10) is increased, the bending slot (35) being adapted to allow the substantially flat, central surface (30) of the foldable portion (20) to be bowed with respect to the main portion (15) by a desired bend angle.

17. The method according to claim 16, wherein:
said foldable portion (20) is formed with the shape of a reed by milling a milled slot (45) across the thickness of the substrate (10) and along the edges (50, 52, 54) of the reed that are to be freed from the main portion (15), and
said bending edge (35) is formed by partially milling the bending slot (35) with a specified depth across the thickness of the substrate (10) and along an edge of the reed to be bended;
the method further comprising:
providing a holding fixture (70) for holding the foldable portion (20) in the desired optical coupling orientation and shaped so as to mechanically couple with at least one of the freed edges (50, 52, 54) of the foldable portion (20) and to an attaching border (80) of the main portion (15) that is oppositely disposed from the bending edge (35).

## Patentansprüche

1. Optoelektronisches Zusammenschaltungsmodul zur Verwendung in der optischen Datenübertragung, umfassend:
eine optisch aktive Vorrichtung (25), die dazu angepasst ist, optische Signale zu empfangen und/oder zu senden; und
ein Substrat (10) mit einem Hauptabschnitt (15) und einem faltbaren Abschnitt (20), der dazu angepasst ist, die optisch aktive Vorrichtung (25) darin anzuordnen;
wobei der faltbare Abschnitt (20) eine im Wesentlichen flache zentrale Fläche (30) zum Anordnen der optisch aktiven Vorrichtung (25) und einen Endteil aufweist, der durch eine Biegekante (35) mechanisch mit dem Hauptabschnitt (15) verbunden ist, wobei der faltbare Abschnitt (20) angepasst ist, an der Biegekante (35) in Bezug auf den Hauptabschnitt (15) in eine gewünschte optische Koppelungsorientierung gefaltet zu werden, bei der eine optische wirksame Achse (OA) der optisch aktiven Vorrichtung (25) im Wesentlichen an einer optischen Übertragungsachse (TT') ausgerichtet ist, die nicht senkrecht zum Hauptabschnitt (15) ist;
**dadurch gekennzeichnet, dass**
das Substrat (10) aus einer einzelnen starren Leiterplatte hergestellt ist, aus der der Hauptabschnitt (15), der faltbare Abschnitt (20) und die Biegekante (35) gebildet sind; wobei
der faltbare Abschnitt (20) aus einem Innenbereich des Substrats (10) gebildet ist, indem ein Schlitz entlang von Kanten (50, 52, 54) des faltbaren Abschnitts (20) gebildet wird, die von dem Hauptabschnitt (15) befreit werden sollen; und
die Biegekante (35) ein Biegeschlitz ist, der an dem Endteil des faltbaren Abschnitts (20) gebildet ist, indem die Dicke des Substrats teilweise auf eine gewünschte Biegedicke reduziert wird, bei der die Flexibilität des Substrats (10) erhöht ist, wobei der Biegeschlitz (35) dazu angepasst ist, ein Krümmen der im Wesentlichen flachen zentralen Fläche (30) des faltbaren Abschnitts (20) in Bezug auf den Hauptabschnitt (15) um einen gewünschten Biegewinkel zuzulassen.

2. Optoelektronisches Zusammenschaltungsmodul nach Anspruch 1, wobei
die optische Übertragungsachse (TT') im Wesentlichen parallel zum Hauptabschnitt (15) ist, und wenn die optische wirksame Achse (OA) der optisch aktiven Vorrichtung (25) im Wesentlichen senkrecht zu ihrer Montagefläche ist, die gewünschte optische Kopplungsorientierung einer Orientierung des faltbaren Abschnitts (20) entspricht, bei der die im Wesentlichen flache zentrale Fläche (30) im Wesentlichen senkrecht zur optischen Übertragungsachse (TT') wird.

3. Optoelektronisches Zusammenschaltungsmodul nach einem der Ansprüche 1 bis 2, wobei:
der Hauptabschnitt (15) eine Öffnung aufweist;
der faltbare Abschnitt (20) durch die Biegekante (35) mechanisch über die Öffnung verbunden ist; und
die Öffnung derart abgemessen ist, dass der faltbare Abschnitt (20) in Bezug auf die Öffnung ungehindert gefaltet werden kann.

4. Optoelektronisches Zusammenschaltungsmodul nach einem der Ansprüche 1 bis 3, wobei:
der faltbare Abschnitt (20) als ein Blatt gebildet ist, das auf dem Substrat (10) gebildet ist, indem ein Frässchlitz (45) entlang den Kanten (50, 52, 54) des Blatts gefräst ist, die von dem Hauptabschnitt (15) befreit werden sollen; und
der Biegeschlitz (65) an dem Endteil des faltbaren Abschnitts (20) gebildet ist, indem die Dicke des Substrats (10) teilweise bis herab auf die gewünschte Biegedicke gefräst wird.

5. Optoelektronisches Zusammenschaltungsmodul nach einem der Ansprüche 1 bis 4, wobei
der faltbare Abschnitt (20) dazu angepasst ist, eine elektrische Schnittstelle zu der darin angeordneten optisch aktiven Vorrichtung (25) zu bilden, und
das Substrat (10) eingebettete Leiterbahnen (67) umfasst, die dazu angepasst sind, eine elektrische Schnittstelle des faltbaren Abschnitts (20) mit dem Hauptabschnitt (15) zu bilden.

6. Optoelektronisches Zusammenschaltungsmodul nach einem der Ansprüche 1 bis 5, wobei:
das Substrat (10) eine Leiterplatte ist, und
die Leiterplatte eine Mehrzahl von Kontakten zum Bilden einer elektrischen
Schnittstelle mit einer Host-Leiterplatte eines Host-Systems umfasst, wobei ein Teil der Kontakte dazu angepasst ist, elektrisch an die optisch aktive Vorrichtung (25) gekoppelt zu sein.

7. Optoelektronisches Zusammenschaltungsmodul nach einem der Ansprüche 1 bis 6, umfassend:
eine Halterung (70), die dazu angepasst ist, an dem faltbaren Abschnitt (20) angebracht zu sein und den faltbaren Abschnitt (20) in der gewünschten optischen Kopplungsorientierung in Bezug auf den Hauptabschnitt (15) zu halten.

8. Optoelektronisches Zusammenschaltungsmodul nach Anspruch 7, wobei
die Halterung (70) ein erstes Fixierungselement (76) und ein zweites Fixierungselement (78) umfasst,
wobei das erste Fixierungselement (76) dazu angepasst ist, in ein erstes Aufnahmeelement einzurasten, das in dem Hauptabschnitt (15) vorgesehen ist, und
das zweite Fixierungselement (78) dazu angepasst ist, in ein zweites Aufnahmeelement einzurasten, das in dem faltbaren Abschnitt (20) vorgesehen ist.

9. Optoelektronisches Zusammenschaltungsmodul nach Anspruch 7 oder Anspruch 8, wobei
die Halterung (70) eine erste Öffnung (85) und eine zweite Öffnung (90) umfasst, die durch einen internen Leitweg (95) mit der ersten Öffnung (85) verbunden ist, und
die erste (85) und die zweite Öffnung (90) in der Halterung (70) angeordnet sind, derart, dass beim Anbringen der Halterung (70) an dem faltbaren Abschnitt (20):
die erste Öffnung (85) dazu angepasst ist, einen Endteil (100) einer optischen Übertragungsleitung aufzunehmen, wobei der Endteil (100) im Wesentlichen an der optischen Übertragungsachse (TT') ausgerichtet ist, und
die zweite Öffnung (90) dazu angepasst ist, dem faltbaren Abschnitt (20) zugewandt zu sein und die darin angeordnete optisch aktive Vorrichtung (25) einzuschließen.

10. Optoelektronisches Zusammenschaltungsmodul nach Anspruch 9, wobei
die erste Öffnung (85) eine Drehhülsenaufnahmebohrung ist, die dazu angepasst ist, direkt mit dem Endteil (100) der optischen Übertragungsleitung (100) verbunden zu werden, wobei der Endteil (100) eine Drehhülse mit einem darin gehaltenen Lichtwellenleiter aufweist.

11. Optoelektronisches Zusammenschaltungsmodul nach Anspruch 9 oder Anspruch 10, wobei
die Halterung (70) ferner eine optische Fokussierungsvorrichtung (97) aufweist, die zwischen der ersten Öffnung (85) und der zweiten Öffnung (90) angeordnet ist, um ein optisches Signal zu fokussieren, das auf dem internen Leitweg (95) an eins von einer optisch aktiven Region (42, 44) der optisch aktiven Vorrichtung (25) und dem Endteil (100) der optischen Übertragungsleitung übertragen wird.

12. Optoelektronisches Zusammenschaltungsmodul nach einem der Ansprüche 9 bis 11, wobei
der interne Leitweg (95) einen optischen Leiter umfasst, der dazu angepasst ist, ein optisches Signal zwischen der optisch aktiven Vorrichtung (25) und dem Endteil der optischen Übertragungsleitung (100) zu übertragen.

13. Optoelektronisches Zusammenschaltungsmodul nach einem der Ansprüche 1 bis 12, wobei
die optisch aktive Vorrichtung (25) ein optisches Sendeempfängermodul ist, das eine elektrooptische Wandlerkomponente und eine optoelektrische Wandlerkomponente umfasst, und
die Halterung (70) dazu angepasst ist, eine optische Übertragungsleitung aufzunehmen, die eine Eingangsübertragungsleitung zum Übertragen eines eingehenden optischen Signals an die optoelektrische Wandlerkomponente und eine Ausgangsübertragungsleitung zum Übertragen eines ausgehenden optischen Signals umfasst, das von der elektrooptischen Wandlerkomponente abgegeben wird.

14. Optoelektronisches Zusammenschaltungsmodul nach einem der Ansprüche 1 bis 13, wobei
die optisch aktive Vorrichtung (25) auf dem faltbaren Abschnitt (20) angeordnet ist und eine elektrische Schnittstelle damit aufweist, und
wobei der faltbare Abschnitt (20) und die optisch aktive Vorrichtung (25) dazu angepasst sind, mittels Oberflächenmontagetechnik eine elektrische Schnittstelle aufzuweisen.

15. Optoelektronisches Zusammenschaltungsmodul nach einem der Ansprüche 1 bis 14, wobei
der Hauptabschnitt (15) eine Mehrzahl elektronischer Schaltungen umfasst, die darin angeordnet sind, und
die Halterung (70) an dem faltbaren Abschnitt (20) und dem Hauptabschnitt (15) anbringbar und davon lösbar ist.

16. Verfahren zum Herstellen eines optoelektronischen
Zusammenschaltungsmoduls zur Verwendung in der optischen Datenübertragung, folgende Schritte umfassend:
Bereitstellen eines Substrats (10) mit einem Hauptabschnitt (15) und einem faltbaren Abschnitt (20), der dazu angepasst ist, eine optisch aktive Vorrichtung (25) darin anzubringen, wobei der faltbare Abschnitt (20) eine im Wesentlichen flache zentrale Fläche (30) zum Anordnen der optisch aktiven Vorrichtung (25) und einen Endteil aufweist, der durch eine Biegekante (35) mechanisch mit dem Hauptabschnitt (15) verbunden ist;
Anbringen der optisch aktiven Vorrichtung (25) an dem faltbaren Abschnitt (20); und
Falten des faltbaren Abschnitts (20) an der Biegekante (35) in Bezug auf den Hauptabschnitt (15) in eine gewünschte optische Koppelungsorientierung, bei der eine optische wirksame Achse (OA) der optisch aktiven Vorrichtung (25) im Wesentlichen an einer optischen Übertragungsachse (TT') ausgerichtet ist, die nicht senkrecht zum Hauptabschnitt (15) ist;
**dadurch gekennzeichnet, dass**
das Substrat (10) aus einer einzelnen starren Leiterplatte hergestellt wird,
der Schritt des Bereitstellens des Substrats (10) das Bilden des Hauptabschnitts (15), des faltbaren Abschnitts (20) und der Biegekante (35) aus dem Substrat (10) selbst beinhaltet; wobei
der faltbare Abschnitt (20) aus einem Innenbereich des Substrats (10) gebildet ist, indem ein Schlitz entlang von Kanten (50, 52, 54) des faltbaren Abschnitts (20) gebildet wird, die von dem Hauptabschnitt (15) befreit werden sollen, und die Biegekante (35) ein Biegeschlitz ist, der an dem Endteil des faltbaren Abschnitts (20) gebildet ist, indem die Dicke des Substrats teilweise auf eine gewünschte Biegedicke reduziert wird, bei der die Flexibilität des Substrats (10) erhöht ist, wobei der Biegeschlitz (35) dazu angepasst ist, ein Krümmen der im Wesentlichen flachen zentralen Fläche (30) des faltbaren Abschnitts (20) in Bezug auf den Hauptabschnitt (15) um einen gewünschten Biegewinkel zuzulassen.

17. Verfahren nach Anspruch 16, wobei:
der faltbare Abschnitt (20) in der Form eines Blatts gebildet wird, indem ein Frässchlitz (45) über die Dicke des Substrats (10) und entlang den Kanten (50, 52, 54) des Blatts gefräst wird, die von dem Hauptabschnitt (15) befreit werden sollen, und
die Biegekante (35) gebildet wird, indem der Biegeschlitz (35) teilweise mit einer festgelegten Tiefe über die Dicke des Substrats (10) und entlang einer Kante des Blatts, die gebogen werden soll, gefräst wird;
wobei das Verfahren ferner Folgendes umfasst:
Bereitstellen einer Halterung (70) zum Halten des faltbaren Abschnitts (20) in der gewünschten optischen Kopplungsorientierung, die derart geformt ist, dass sie an wenigstens eine der befreiten Kanten (50, 52, 54) des faltbaren Abschnitts (20) und an einen Anbringungsrand (80) des Hauptabschnitts (15) koppelt, der gegenüber der Biegekante (35) angeordnet ist.

## Revendications

1. Module opto-électronique d'interconnexion destiné à être utilisé dans des communications optiques, comprenant :
un dispositif optiquement actif (25) adapté pour recevoir et/ou transmettre des signaux optiques ; et
un substrat (10) ayant une partie principale (15) et une partie pliable (20) conçue pour y monter le dispositif optiquement actif (25) ;
dans lequel la partie pliable (20) présente une surface centrale, sensiblement plane (30), pour agencer le dispositif optiquement actif (25) et une partie d'extrémité qui est reliée mécaniquement à la partie principale (15) par une arête de pliage (35), la partie pliable (20) étant adaptée pour être pliée au niveau de l'arête de pliage (35) par rapport à la partie principale (15) dans une orientation de couplage optique souhaitée pour laquelle un axe optique opératoire (AO) du dispositif optiquement actif (25) est sensiblement aligné sur un axe de transmission optique (TT') qui n'est pas perpendiculaire à la partie principale (15) ;
**caractérisé en ce que**
le substrat (10) est fait à partir d'une seule carte de circuit imprimé rigide, à partir de laquelle la partie principale (15), la partie pliable (20) et l'arête de pliage (35) sont formées, dans lequel
la partie pliable (20) est formée à partir d'une zone intérieure du substrat (10) en formant une fente le long des bords (50, 52, 54) de la partie pliable (20) qui doit être libérée de la partie principale (15) ; et
l'arête de pliage (35) est une arête de pliage formée à la partie d'extrémité de la partie pliable (20) en réduisant partiellement l'épaisseur du substrat jusqu'à une épaisseur de pliage souhaitée pour laquelle la flexibilité du substrat (10) est augmentée, la fente de pliage (35) étant adaptée pour permettre à la surface centrale, sensiblement plane (30), de la partie pliable (20) destinée à être courbée par rapport à la partie principale (15) d'un angle de pliage souhaité.

2. Module opto-électronique d'interconnexion selon la revendication 1, dans lequel
ledit axe de transmission optique (TT') est sensiblement parallèle à la partie principale (15), et lorsque l'axe optique opératoire (AO) du dispositif optiquement actif (25) est sensiblement perpendiculaire à sa surface de montage, l'orientation souhaitée dudit couplage optique correspond à une orientation de la partie pliable (20) pour laquelle ladite surface centrale, sensiblement plane (30), devient sensiblement perpendiculaire à l'axe de transmission optique (TT').

3. Module d'interconnexion opto-électronique selon l'une quelconque des revendications 1 à 2, dans lequel :
la partie principale (15) présente une ouverture ;
la partie pliable (20) est reliée mécaniquement au-dessus de l'ouverture par l'arête de pliage (35) ; et
l'ouverture est dimensionnée de manière à permettre à la partie pliable (20) d'être pliée librement par rapport à l'ouverture.

4. Module d'interconnexion opto-électronique selon l'une quelconque des revendications 1 à 3, dans lequel :
ladite partie pliable (20) est en forme de roseau qui est formé sur le substrat (10) par fraisage d'une fente fraisée (45) le long des bords (50, 52, 54) du roseau qui doivent être libérés de la partie principale (15) ; et
ladite fente de pliage (65) est formée à la partie d'extrémité de la partie pliable (20) en fraisant partiellement l'épaisseur du substrat (10) jusqu'à l'épaisseur de pliage souhaitée.

5. Module d'interconnexion opto-électronique selon l'une quelconque des revendications 1 à 4, dans lequel
la partie pliable (20) est adaptée pour interfacer électriquement le dispositif optiquement actif (25) agencé dans celui-ci, et
le substrat (10) comprend des chemins conducteurs incorporés (67) adaptés pour interfacer électriquement la partie pliable (20) avec la partie principale (15).

6. Module opto-électronique selon l'une quelconque des revendications 1 à 5, dans lequel :
le substrat (10) est une carte de circuit imprimé, et
la carte de circuit imprimé comprend une pluralité de contacts pour s'interfacer électriquement avec une carte de circuit d'hôte d'un système hôte, une partie desdits contacts étant adaptés pour être couplés électriquement au dispositif optiquement actif (25).

7. Module d'interconnexion opto-électronique selon l'une quelconque des revendications 1 à 6, comprenant :
un dispositif de maintien (70) adapté pour être fixé à la partie pliable (20) et pour maintenir la partie pliable (20) dans l'orientation de couplage optique désirée par rapport à la partie principale (15).

8. Module d'interconnexion opto-électronique selon la revendication 7, dans lequel
le dispositif de maintien (70) comprend un premier élément de fixation (76) et un second élément de fixation (78),
le premier élément de fixation (76) est adapté pour s'enclencher à un premier élément de réception prévu dans la partie principale (15), et
le second élément de fixation (78) est adapté pour s'enclencher à un second élément de réception prévu dans la partie pliable (20).

9. Module opto-électronique d'interconnexion selon la revendication 7 ou la revendication 8, dans lequel
le dispositif de maintien (70) comprend une première ouverture (85) et une seconde ouverture (90) qui est reliée à la première ouverture (85) par un chemin de guidage interne (95), et
la première (85) et la seconde ouverture (90) sont disposées dans le dispositif de maintien (70) de sorte que lorsque le dispositif de maintien (70) est fixé à la partie pliable (20) :
la première ouverture (85) est adaptée pour recevoir une partie d'extrémité (100) d'une ligne de transmission optique, ladite partie d'extrémité (100) étant sensiblement alignée sur l'axe optique de transmission (TT'), et
la seconde ouverture (90) est adaptée pour faire face à la partie pliable (20) et pour enfermer le dispositif optiquement actif (25) disposé dans celui-ci.

10. Module opto-électronique selon la revendication 9, dans lequel la première ouverture (85) est un alésage de réception d'un embout adapté pour s'interconnecter directement à la partie d'extrémité (100) de la ligne de transmission optique (100), ladite partie d'extrémité (100) ayant un embout avec une fibre optique dans celle-ci.

11. Module opto-électronique d'interconnexion selon la revendication 9 ou la revendication 10, dans lequel le dispositif de maintien (70) comprend en outre un dispositif optique de focalisation (97) disposé entre la première ouverture (85) et la seconde ouverture (90) pour focaliser un signal optique qui est transmis dans le chemin de guidage interne (95) sur l'une d'une région optiquement active (42, 44) du dispositif optiquement actif (25) et de la partie d'extrémité (100) de la ligne de transmission optique.

12. Module opto-électronique d'interconnexion selon l'une quelconque des revendications 9 à 11, dans lequel le chemin de guidage interne (95) comprend un guide optique adapté pour transmettre un signal optique entre le dispositif optiquement actif (25) et la partie d'extrémité de la ligne de transmission optique (100).

13. Module opto-électronique d'interconnexion selon l'une quelconque des revendications 1 à 12, dans lequel ledit dispositif optiquement actif (25) est un module émetteur-récepteur optique comprenant un composant convertisseur électro-optique et un composant convertisseur opto-électrique, et
ledit dispositif de maintien (70) est adapté pour recevoir une ligne de transmission optique comprenant une ligne de transmission entrante pour transmettre un signal optique entrant au composant convertisseur opto-électrique et une ligne de transmission de sortie pour transmettre un signal optique sortant émis par le composant convertisseur électro-optique.

14. Module opto-électronique d'interconnexion selon l'une quelconque des revendications 1 à 13, dans lequel ledit dispositif optiquement actif (25) est disposé sur et électriquement interfacé à la partie pliable (20), et
dans lequel la partie pliable (20) et le dispositif optiquement actif (25) sont adaptés pour être interfacés électriquement par technologie de montage en surface.

15. Module opto-électronique d'interconnexion selon l'une quelconque des revendications 1 à 14, dans lequel la partie principale (15) comprend une pluralité de circuits électroniques qui y sont disposés, et
le dispositif de maintien (70) peut être fixé à et retiré de la partie pliable (20) et de la partie principale (15).

16. Procédé de fabrication d'un module opto-électronique d'interconnexion destiné à être utilisé dans des communications optiques, comprenant les étapes consistant à :
fournir un substrat (10) ayant une partie principale (15) et une partie pliable (20) adaptée pour monter un dispositif optiquement actif (25) dans celui-ci, la partie pliable (20) ayant une surface centrale, sensiblement plane (30), pour agencer le dispositif optiquement actif (25) et une partie d'extrémité qui est reliée mécaniquement à la partie principale (15) par une arête de pliage (35) ;
monter le dispositif optiquement actif (25) sur la partie pliable (20) ; et
plier la partie pliable (20) au niveau de l'arête de pliage (35) par rapport à la partie principale (15) dans une orientation de couplage optique désirée pour laquelle un axe optique opératoire (AO) du dispositif optiquement actif (25) est sensiblement aligné sur un axe de transmission optique (TT') qui n'est pas perpendiculaire à la partie principale (15) ;
**caractérisé en ce que**
le substrat (10) est fabriqué à partir d'une seule carte de circuit imprimé rigide,
l'étape consistant à fournir le substrat (10) comprenant la formation de la partie principale (15), la partie pliable (20) et
l'arête de pliage (35) à partir du substrat (10) lui-même ; dans lequel
la partie pliable (20) est formée à partir d'une zone interne du substrat (10) en formant une fente le long des bords (50, 52, 54) de la partie pliable (20) qui doivent être libérés de la partie principale (15) et
l'arête de pliage (35) est une fente de pliage formée à la partie d'extrémité de la partie pliable (20) en réduisant partiellement l'épaisseur du substrat jusqu'à une épaisseur souhaitée de pliage pour laquelle la flexibilité du substrat (10) est augmentée, la fente de pliage (35) étant adaptée pour permettre à la surface centrale, sensiblement plane (30), de la partie pliable (20) d'être inclinée par rapport à la partie principale (15) d'un angle de pliage souhaité.

17. Procédé selon la revendication 16, dans lequel :
ladite partie pliable (20) est formée avec la forme d'un roseau par fraisage d'une fente fraisée (45) à travers l'épaisseur du substrat (10) et le long des bords (50, 52, 54) du roseau qui doivent être libérés de la partie principale (15) ; et
ladite arête de pliage (35) est formée en fraisant partiellement la fente de pliage (35) à une profondeur spécifiée dans l'épaisseur du substrat (10) et le long d'un bord du roseau à plier ;
le procédé comprenant en outre :
la fourniture d'un dispositif de maintien (70) pour maintenir la partie pliable (20) dans l'orientation de couplage optique souhaitée et formée de manière à s'accoupler mécaniquement avec au moins un des bords libérés (50, 52, 54) de la partie pliable (20) et à un bord de connexion (80) de la partie principale (15) qui est disposée à l'opposé de l'arête de pliage (35).
